Europäisches Patentamt

European Patent Office

Office européen des brevets

(11) Numéro de publication: **0 214 886**
**B1**

(12) **FASCICULE DE BREVET EUROPEEN**

(51) Int. Cl.⁵: **H05K 9/00**

(45) Date de publication du fascicule du brevet:
**03.10.90**

(21) Numéro de dépôt: **86401727.2**

(22) Date de dépôt: **01.08.86**

(54) Dispositif de liaison entre enceintes du type cage de Faraday.

(30) Priorité: **02.08.85 FR 8511884**

(43) Date de publication de la demande:
**18.03.87 Bulletin 87/12**

(45) Mention de la délivrance du brevet:
**03.10.90 Bulletin 90/40**

(84) Etats contractants désignés:
**DE GB IT NL**

(56) Documents cités:
**FR-A- 858 402**
**FR-A- 1 036 128**
**GB-A- 1 285 189**
**US-A- 1 994 905**
**US-A- 4 115 656**

(73) Titulaire: **THOMSON-CSF, 51, Esplanade du Général de Gaulle, F-92800 Puteaux(FR)**

(72) Inventeur: **Bellot, Guy, THOMSON - CSF SCPI 19, avenue de Messine, F-75008 Paris(FR)**
Inventeur: **Side, Solly, THOMSON - CSF SCPI 19, avenue de Messine, F-75008 Paris(FR)**

(74) Mandataire: **Courtellemont, Alain et al, THOMSON-CSF SCPI, F-92045 PARIS LA DEFENSE CEDEX 67(FR)**

**Description**

La présente invention concerne un dispositif de liaison entre enceintes du type cage de Faraday, c'est-à-dire un dispositif permettant d'assurer les échanges de signaux et le transfert d'énergie entre les enceintes sans, pour cela, permettre à des perturbations d'origine extérieure aux enceintes, de pénétrer dans les enceintes.

Il est connu de réaliser de tels dispositifs en reliant les enceintes les unes aux autres à l'aide de câbles ordinaires et en associant à ces câbles, là où ils pénètrent dans les enceintes, des moyens de protection contre les parasites d'origine extérieure aux enceintes ; ces moyens de protection comportent généralement un éclateur pour réaliser une protection contre la foudre et un filtre destiné à arrêter les autres parasites extérieurs. Il est à noter que dans ces dispositifs de liaison, dès que le nombre d'enceintes est supérieur à 2, les câbles forment des boucles particulièrement favorables à la capture de parasites ; dans le cas de trois enceintes, par exemple, la boucle constitue une sorte de triangle dont les sommets sont occupés par les enceintes.

Il est également connu de réaliser ces dispositifs de liaison à l'aide de câbles blindés terminés par des connecteurs protégés contre les parasites ; les résultats obtenus sur le plan de la protection contre les parasites sont bons mais le prix de revient du dispositif est élevé en raison des câbles et des connecteurs employés.

De plus avec les deux types de dispositifs de liaison dont il vient d'être question, l'adjonction d'un nouveau conducteur entre deux des enceintes n'est pas facile : dans le premier cas elle nécessite que le nouveau câble soit lui aussi protégé, à chacune de ses extrémités, par un éclateur et un filtre, et dans le second cas le nouveau câble blindé doit être muni, à chacune de ses extrémités, d'un connecteur qui nécessite des travaux d'adaptation mécanique, dont en particulier des perçages, au niveau de la paroi des deux enceintes reliées par ce câble.

Le but de la présente invention est de proposer un dispositif de liaison ne présentant pas ou présentant à un degré moindre les inconvénients mentionnés ci-avant au sujet des dispositifs de liaison connus.

Ceci est obtenu, en particulier, par l'utilisation de blindages faits de gaines souples, bonnes conductrices de l'électricité, à l'intérieur desquelles sont passés les câbles électriques.

Selon l'invention il est proposé un dispositif de liaison entre n (n entier) enceintes du type cage de Faraday, présentant des accès de couplage, ce dispositif comportant des conduits à l'intérieur desquels sont disposés des câbles électriques assurant les liaisons entre les enceintes, ces conduits étant formés à l'aide de gaines souples, bonnes conductrices de l'électricité, caractérisé en ce que, n étant supérieur à 2, les conduits sont au nombre de n et les enceintes présentent respectivement n accès de couplage, en ce que le dispositif forme une étoile à n branches, dont les branches sont les conduits et dont le centre est formé par une chambre de tirage constituée par une boîte en matériau bon conducteur de l'électricité, comportant n accès, en ce que les n conduits raccordent les n accès de couplage aux n accès de la boîte et en ce que le dispositif comporte également une prise de terre unique cette prise de terre reliant la chambre de tirage à la terre.

La présente invention sera mieux comprise et d'autres caractéristiques apparaîtront à l'aide de la description ci-après et des figures s'y rapportant qui représentent:

- la figure 1, une vue schématique d'enceintes reliées entre elles par un dispositif de liaison selon l'invention,
- les figures 2 et 3 des vues de détails, en coupe du dispositif de liaison selon la figure 1.

Sur les différentes figures les éléments correspondants sont désignés par les mêmes repères.

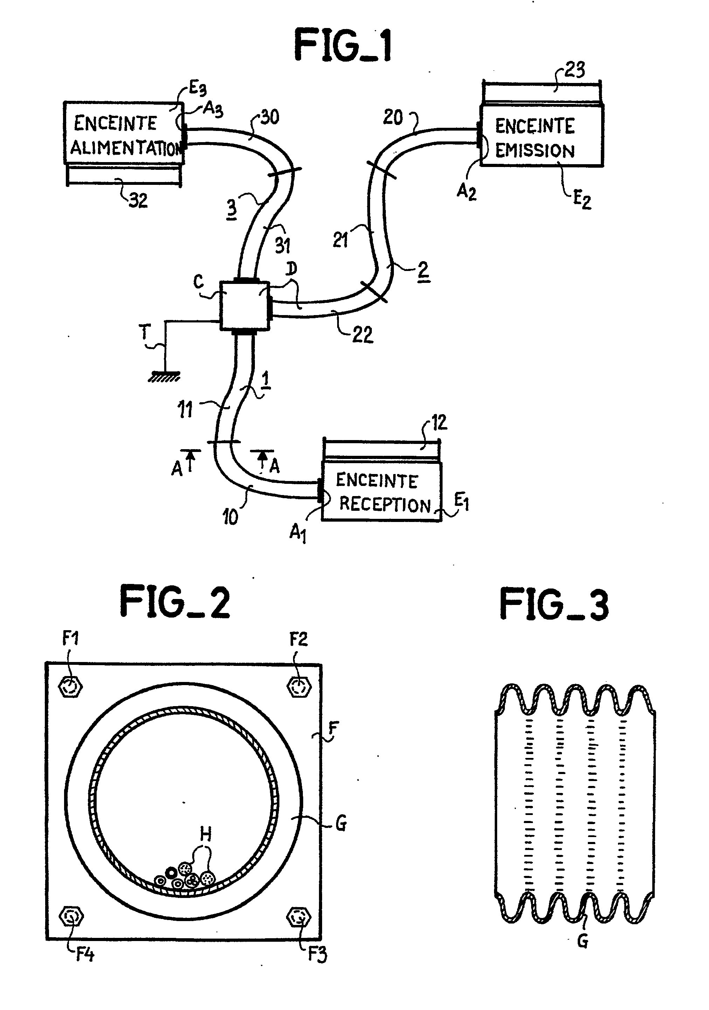

La figure 1 montre, schématiquement et vu de dessus, un groupement de trois enceintes du type cage de Faraday, E1, E2, E3, réunies par un dispositif de liaison. Sur cette figure les proportions n'ont pas été respectées dans le but de mieux faire ressortir les caractéristiques du dispositif de liaison; par contre des indications, quant aux dimensions réelles des éléments du dispositif ayant servi de modèle pour la description, seront données à titre d'exemple.

Les enceintes E1, E2, E3, de la figure 1, sont des cabines transportées sur camions; elles sont généralement désignées par les techniciens sous leur appellation anglo-saxonne de "shelters". Ces enceintes sont construites pour former des sortes de cages de Faraday afin d'éviter que les circuits électroniques qu'elles contiennent ne soient perturbés par les rayonnements parasites extérieurs. Dans l'exemple décrit les trois enceintes sont relatives respectivement au bloc de réception et de traitement de l'information, au bloc d'émission et au bloc d'alimentation d'un émetteur-récepteur mobile de faisceau hertzien. Il est à noter par ailleurs que, sur la figure 1, les antennes situées sur les enceintes d'émission, E2, et de réception, E1, n'ont pas été représentées.

Les enceintes E1, E2, E3 présentent respectivement trois accès de couplage A1, A2, A3 percés dans leur paroi et par lesquels passent des câbles électriques ordinaires, c'est-à-dire non blindés, pour assurer les liaisons électriques entre ces enceintes. Ces câbles ne sont pas visibles sur la figure 1 car ils se trouvent situés, pour partie de leur longueur, dans les enceintes et, pour le reste de leur longueur, à l'intérieur d'un ensemble protecteur creux, D, en forme d'étoile à trois branches dont le centre est constitué par une chambre de tirage, C ; les branches de l'étoile sont constituées par des conduits 1, 2, 3. La chambre de tirage est une boîte métallique munie d'une prise de terre par piquet, T, qui constitue la prise de terre générale de tout l'ensemble selon la figure 1. La chambre de tirage est munie de trois accès sur lesquels sont respectivement couplés, à l'une de leurs extrémités, les trois conduits ; les conduits 1, 2, 3 sont raccordés, à leur autre extrémité, respectivement aux trois accès de couplage A1, A2, A3.

Les conduits 1, 2, 3 sont formés à l'aide de manchons en gaine souple, en métal bon conducteur de l'électricité : manchons 10 et 11 formant le conduit 1, manchons 20, 21, 22 formant le conduit 2 et manchons 30, 31 formant le conduit 3. Tous ces manchons sont identiques et comportent une gaine annelée, souple, d'une longueur de 6 mètres ; à chacune des extrémités de la gaine est fixée, par soudure, un flasque permettant la fixation, par écrous, du manchon considéré soit sur un autre manchon, soit sur l'une des enceintes E1, E2, E3, soit sur la chambre de tirage C. Il est à noter de plus que dans la vue de dessus selon la figure 1 apparaissent trois autres manchons 12, 23, 32 respectivement accolés aux enceintes E1, E2, E3 sur l'un des grands côtés de ces enceintes. Dans l'exemple décrit les enceintes étaient des enceintes de vingt pieds de long, soit environ 6,10 mètres, et chacune disposait, sur l'un de ses grands côtés, de moyens d'accrochage pour le stockage, à différentes hauteurs, de cinq manchons ; ces manchons permettent donc de réaliser des conduits de 30 mètres et même plus en combinant, pour un conduit, des raccords provenant de plusieurs enceintes.

En ce qui concerne la chambre de tirage C, il s'agit d'un boîtier métallique, sensiblement cubique, de 30 cm d'arête ; ce boîtier est muni d'un couvercle de visite, de trois accès relatifs aux trois conduits 1 à 3 et de barrettes de raccordement pour le raccordement entre eux des câbles provenant des différentes enceintes. Au sujet de l'introduction des câbles électriques dans les manchons, il est à noter qu'une façon pratique d'y procéder est de faire passer, dans le manchon, un boulon auquel est accroché un cordage ; le cordage servira alors à introduire les câbles dans le manchon.

La figure 2 est une vue en coupe du manchon de la figure 1 par un plan de coupe perpendiculaire au plan de la figure 1 qu'il croise suivant une ligne AA indiquée sur la figure 1. Cette figure montre la gaine annelée, G, dont les diamètres extérieur et intérieur sont d'environ 12 et 10 cm ; cette gaine annelée est du type des gaines annelées qui sont communément employées pour le transport des gaz et des fluides ; dans l'exemple décrit elle est en acier inoxydable mais elle pourrait également être en cuivre ou en laiton.

La figure 2 montre également les câbles électriques, H, disposés à l'intérieur de la gaine et le flasque F permettant la fixation du manchon 10 sur le manchon 11 selon la figure 1 ; il s'agit d'une plaque formée par un carré en acier inoxydable, de 14 cm de côté, percé de cinq trous : un trou de 12 cm de diamètre dont le centre est confondu avec le point de rencontre des diagonales du carré et quatre trous de fixation, F1 à F4, situés au voisinage des angles de la plaque carrée et représentés en traits interrompus, comme vus par transparence sous les têtes des écrous qui les traversent. La gaine G est soudée sur les bords du trou de 12 cm de diamètre.

La figure 3 est une vue en coupe transversale d'un morceau de la gaine G utilisée pour réaliser les manchons de la figure 1. Comme il a déjà été dit plus avant, il s'agit d'une gaine annelée communément employée pour des transports de gaz ou de liquides ; dans le cas de l'exemple décrit l'ondulation de cette gaine a une épaisseur de 10 mm et un écart entre deux sommets successifs également de 10 mm.

Dans le cas où le nombre d'enceintes à relier par un dispositif selon l'invention est réduit à deux; l'utilisation d'une chambre de tirage n'est pas indispensable, les deux conduits relatifs aux deux enceintes se confondant en un seul conduit et la prise de terre se faisant, de préférence, à partir d'un point situé au milieu de ce conduit tandis que le raccordement électrique des câbles se fait soit au niveau de la jonction entre deux manchons soit au niveau de la jonction entre une des enceintes et le conduit.

**Revendications**

1. Dispositif de liaison entre n (n entier) enceintes (E1, E2, E3) du type cage de Faraday, présentant des accès de couplage (A1, A2, A3), ce dispositif comportant des conduits (1, 2, 3) à l'intérieur desquels sont disposés des câbles électriques (H) assurant les liaisons entre les enceintes, ces conduits étant formés à l'aide de gaines souples (G), bonnes conductrices de l'électricité, caractérisé en ce que, n étant supérieur à 2, les conduits sont au nombre de n et les enceintes présentent n accès de couplage (A1, A2, A3), en ce que le dispositif forme une étoile à n branches, dont les branches sont les conduits (1, 2, 3) et dont le centre est formé par une chambre de tirage (C) constituée par une boîte en matériau bon conducteur de l'électricité, comportant n accès, en ce que les n conduits raccordent les n accès de couplage aux n accès de la boîte et en ce que le dispositif comporte également une prise de terre unique (T) cette prise de terre reliant la chambre de tirage à la terre.

2. Dispositif selon la revendication 1, caractérisé en ce que au moins une partie des conduits est constituée de manchons juxtaposés (10, 11; 20, 21, 22; 30, 31), la longueur des manchons d'un conduit donné étant au plus égale à la plus grande dimension des parois extérieures de l'enceinte donnée que le conduit donné raccorde et en ce que, lors du transport de l'enceinte donnée, les manchons formant le conduit donné sont fixés sur la paroi extérieure de l'enceinte donnée.

**Claims**

1. A device for interconnecting n housings (E1, E2, E3) of the Faraday cage type (n being an integer) having coupling accesses (A1, A2, A3), the device comprising ducts (1, 2, 3) in which electric cables (H) for ensuring the connection between the housings are disposed, said ducts being formed by means of flexible tubes (G) made from electrically conducting material, characterized in that, with n being greater than 2, the number of ducts is n and the housings are provided with n coupling accesses (A1, A2, A3), that the device assumes the shape of a star with n peaks, with the peaks being formed by the ducts (1, 2, 3) and the center being formed by a linking chamber (C), which is constituted of a casing made of an electrically conducting material and which comprises n accesses, that the n ducts are arranged to connect the n coupling accesses to the n accesses of the casing, and that the device also comprises a single ground connection (T), which connects the linking chamber to ground.

2. A device according to claim 1, characterized in that at least one part of the ducts is constituted of juxtaposed sleeves (10, 11; 20, 21, 22; 30, 31), with the length of the sleeves of a given duct being at least equal to the largest dimension of the external walls of the respective housing connected by the given duct, and that during transportation of said housing the sleeves forming the given duct are fixed to the external wall of said housing during.

## Patentansprüche

1. Verbindungseinrichtung zwischen n Gehäusen (E1, E2, E3) (n ganzahlig) vom Typ eines Faradaykäfigs, der Kupplungsanschlüsse (A1, A2, A3) besitzt, wobei die Einrichtung Kanäle (1, 2, 3) aufweist, in denen elektrische Kabel (H) zu Verbindung der Gehäuse untereinander untergebracht sind und die aus elastischen Hüllrohren (G) aufgebaut sind, die gute elektrische Leiter sind, dadurch gekennzeichnet, daß n größer als 2 ist und die Anzahl der Kanäle n beträgt und die Gehäuse n Kupplungsanschlüsse (A1, A2, A3) besitzen, daß die Einrichtung einen Stern mit n Zacken bildet, die die Kanäle (1, 2, 3) sind, wobei das Zentrum des Sterns aus einer Anschlußkammer (C) besteht, die aus einem elektrisch gut leitenden Gehäuse mit n Zugängen besteht, daß die n Kanäle die n Kupplungsanschlüsse mit den n Zugängen des Gehäuses verbinden und daß die Einrichtung weiter einen gemeinsamen Erdungsanschluß (T) aufweist, der die Anschlußkammer mit Erde verbindet.

2. Einrichtung nach Anspruch 1, dadurch gekennzeichnet, daß mindestens ein Teil der Kanäle aus aneinander anschließenden Hülsen (10, 11; 20, 21, 22; 30, 31) besteht, wobei die Länge der Hülsen eines bestimmten Kanals mindestens der größten Abmessung der äußeren Wände des betreffenden Gehäuses entspricht, den der betreffende Kanal verbindet, und daß die den betreffenden Kanal bildenden Hülsen während des Transportes des betreffenden Gehäuses an der Außenwand des betreffenden Gehäuses befestigt werden.

# FIG_1

ENCEINTE
ALIMENTATION

$E_3$
$A_3$
30
3
31
32

20
21
2
22

ENCEINTE
EMISSION

23
$A_2$
$E_2$

C
D
T

1
11
10

$A$
$A$

ENCEINTE
RECEPTION

12
$E_1$
$A_1$

# FIG_2

F1
F2
F
G
H
F4
F3

# FIG_3

G